(19) Europäisches Patentamt
European Patent Office
Office européen des brevets

(11) EP 2 157 118 A1

(12) EUROPEAN PATENT APPLICATION

(43) Date of publication:
**24.02.2010 Bulletin 2010/08**

(51) Int Cl.:
***C08G 73/00*** *(2006.01)* ***C08G 12/06*** *(2006.01)*
***C08G 12/26*** *(2006.01)*

(21) Application number: **09167040.6**

(22) Date of filing: **03.08.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **18.08.2008 US 193174**

(71) Applicant: **Xerox Corporation**
**Rochester, NY 14644 (US)**

(72) Inventor: **Li, Yuning**
**128044, Singapore (SG)**

(74) Representative: **Grünecker, Kinkeldey, Stockmair & Schwanhäusser**
**Anwaltssozietät**
**Leopoldstrasse 4**
**80802 München (DE)**

# (54) Semiconducting Polymers

(57) A semiconducting polymer is selected from the group consisting of Formulas (I) and (II):

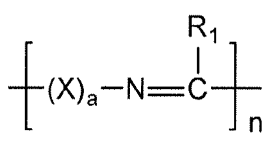

**Formula (I)**

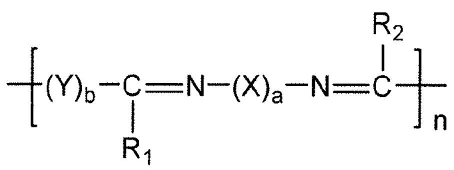

**Formula (II)**

where X, Y, a, b, n, $R_1$, and $R_2$ are as defined herein.

*FIG. 1*

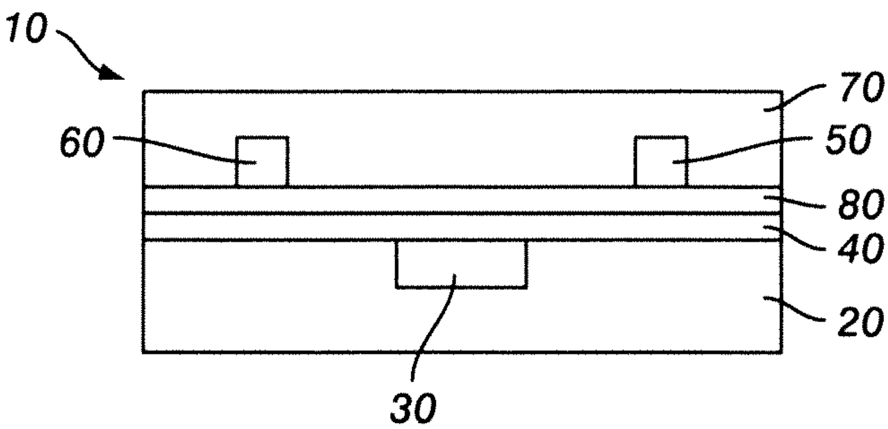


EP 2 157 118 A1

## Description

## BACKGROUND

The present disclosure relates, in various embodiments, to compositions and processes suitable for use in electronic devices, such as thin film transistors ("TFT"s). The present disclosure also relates to components or layers produced using such compositions and processes, as well as electronic devices containing such materials.

Thin film transistors (TFTs) are fundamental components in modern-age electronics, including, for example, sensors, image scanners, and electronic display devices. TFT circuits using current mainstream silicon technology may be too costly for some applications, particularly for large-area electronic devices such as backplane switching circuits for displays (e.g., active matrix liquid crystal monitors or televisions) where high switching speeds are not essential. The high costs of silicon-based TFT circuits are primarily due to the use of capital-intensive silicon manufacturing facilities as well as complex high-temperature, high-vacuum photolithographic fabrication processes under strictly controlled environments. It is generally desired to make TFTs which have not only much lower manufacturing costs, but also appealing mechanical properties such as being physically compact, lightweight, and flexible. Organic thin film transistors (OTFTs) may be suited for those applications not needing high switching speeds or high densities.

TFTs are generally composed of a supporting substrate, three electrically conductive electrodes (gate, source and drain electrodes), a channel semiconducting layer, and an electrically insulating gate dielectric layer separating the gate electrode from the semiconducting layer.

It is desirable to improve the performance of known TFTs. Performance can be measured by at least three properties: the mobility, current on/off ratio, and threshold voltage. The mobility is measured in units of $cm^2/V{\cdot}sec$; higher mobility is desired. A higher current on/off ratio is desired. Threshold voltage relates to the bias voltage needed to be applied to the gate electrode in order to allow current to flow. Generally, a threshold voltage as close to zero (0) as possible is desired.

## BRIEF DESCRIPTION

The present disclosure provides:

(1) A semiconducting polymer selected from the group consisting of Formulas (I) and (II):

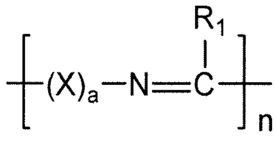

**Formula (I)**

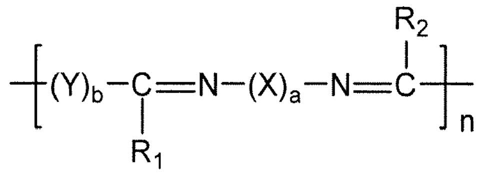

**Formula (II)**

wherein

$R_1$ and $R_2$ are independently selected from hydrogen, alkyl, substituted alkyl, aryl, substituted aryl, and heteroaryl;
X and Y are independently a conjugated divalent moiety;
a and b are independently integers from 0 to about 10; and
n is an integer from 2 to about 5,000.

(2) The semiconducting polymer of (1), wherein each X and Y moiety is selected from

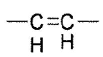 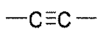 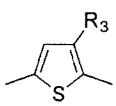 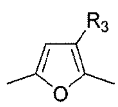 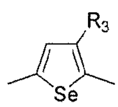 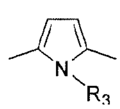 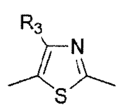 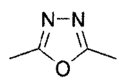

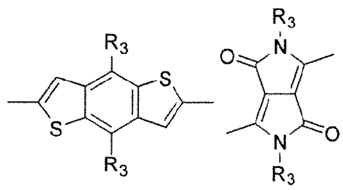
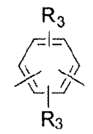
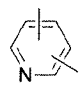
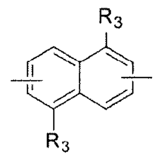
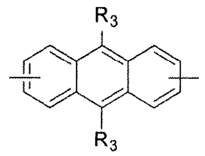

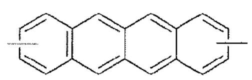
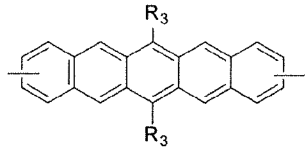
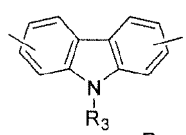
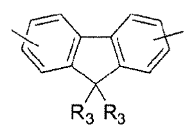

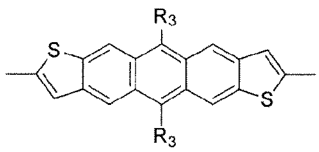
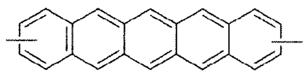
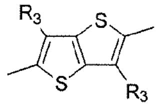

wherein $R_3$ is independently selected from hydrogen, alkyl, substituted alkyl, aryl, substituted aryl, and heteroaryl.

(3) The semiconducting polymer of (1), wherein $R_1$ and $R_2$ are hydrogen.

(4) The semiconducting polymer of (1), wherein $R_1$ and $R_2$ are independently $C_1$-$C_{20}$ alkyl.

(5) The semiconducting polymer of (1), being of Formula (II), wherein a is zero.

(6) The semiconducting polymer of (1), wherein the semiconducting polymer is selected from Formula (I-a) through (I-h):

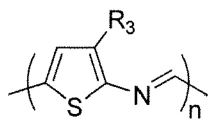
**Formula (I-a)**

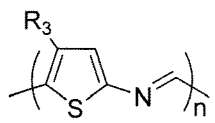
**Formula (I-b)**

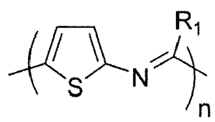
**Formula (I-c)**

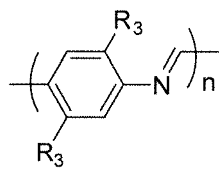
**Formula (I-d)**

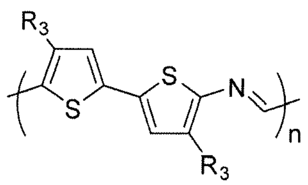
**Formula (I-e)**

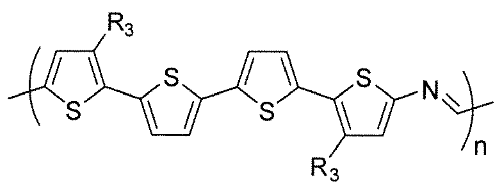
**Formula (I-f)**

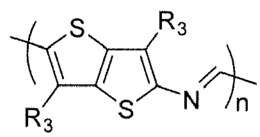

**Formula (I-g)**

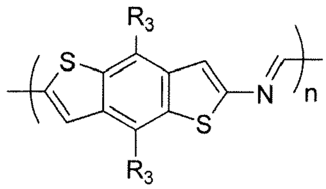

**Formula (I-h)**

wherein $R_1$ and $R_3$ are independently selected from alkyl, substituted alkyl, aryl, substituted aryl, and heteroaryl.
(7) The semiconducting polymer of (6), wherein $R_3$ is independently $C_1$-$C_{20}$ alkyl.
(8) The semiconducting polymer of (6), wherein the semiconducting polymer is Formula (I-b).
(9) The semiconducting polymer of (1), wherein the semiconducting material is selected from one of Formulas (II-a) through (II-v):

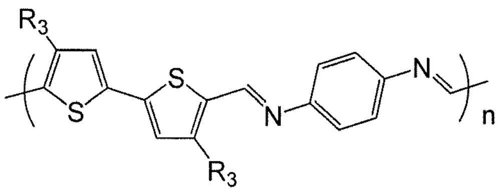

**Formula (II-a)**

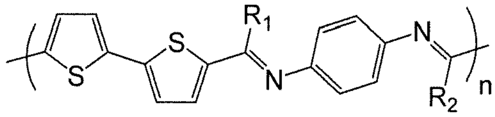

**Formula (II-b)**

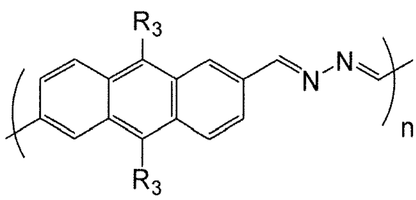

**Formula (II-c)**

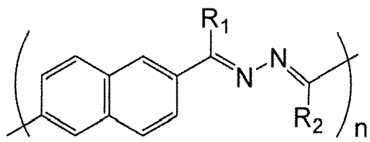

**Formula (II-d)**

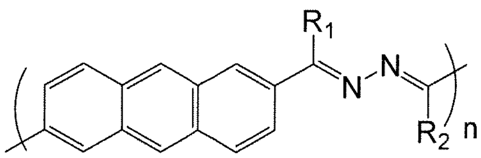

**Formula (II-e)**

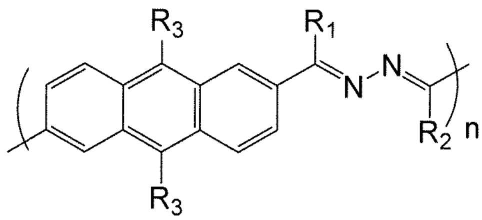

**Formula (II-f)**

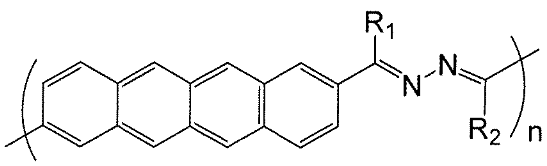

**Formula (II-g)**

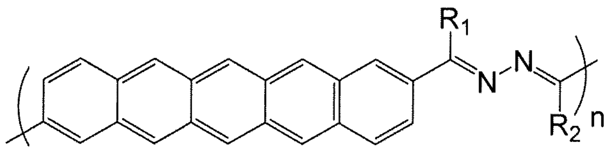

**Formula (II-h)**

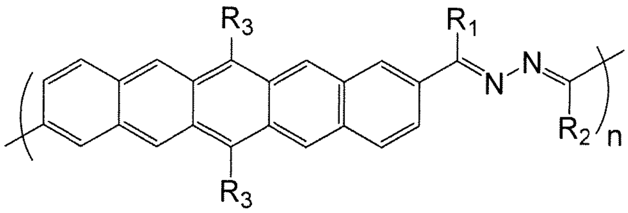

**Formula (II-i)**

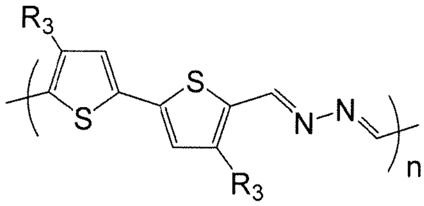

**Formula (II-j)**

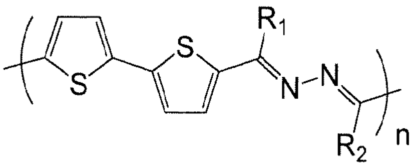

**Formula (II-k)**

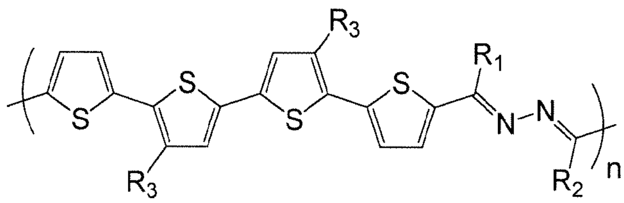

**Formula (II-l)**

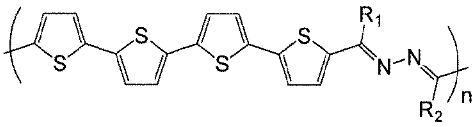

**Formula (II-m)**

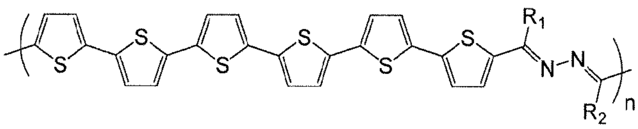

**Formula (II-n)**

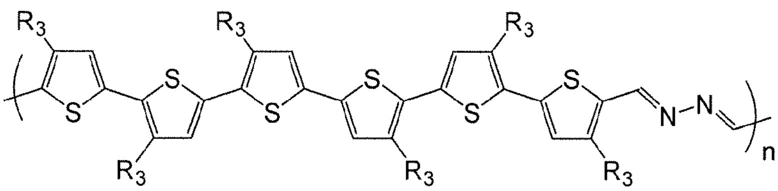

**Formula (II-o)**

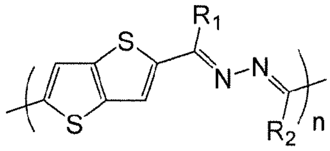

**Formula (II-p)**

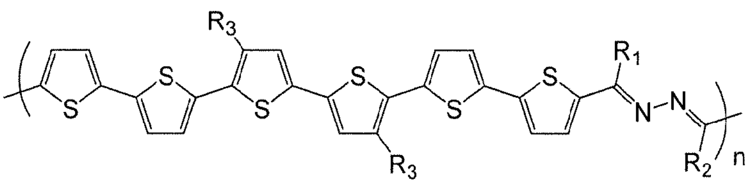

**Formula (II-q)**

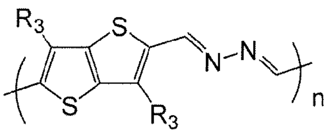

**Formula (II-r)**

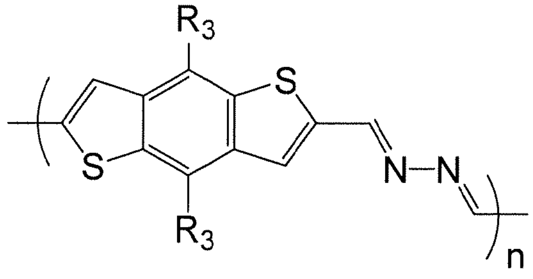

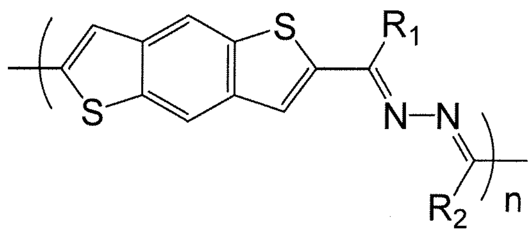

**Formula (II-s)** **Formula (II-t)**

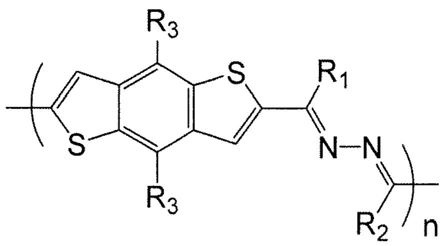

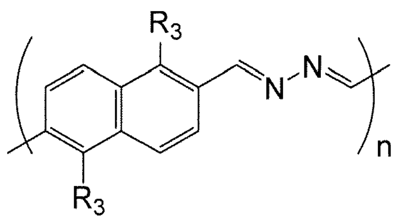

**Formula (II-u)** **Formula (II-v)**

wherein $R_1$, $R_2$, and $R_3$ are independently selected from alkyl, substituted alkyl, aryl, substituted aryl, and heteroaryl.

(10) The semiconducting polymer of (9), wherein $R_1$, $R_2$, and $R_3$ are independently $C_1$-$C_{20}$ alkyl.

(11) The semiconducting polymer of (9), wherein the semiconducting polymer is Formula (II-j.)

(12) The semiconducting polymer of (1), wherein the heteroaryl is selected from thienyl, furanyl, pyridinyl, oxazoyl, pyrroyl, triazinyl, imidazoyl, pyrimidinyl, pyrazinyl, oxadiazoyl, pyrazoyl, triazoyl, thiazoyl, thiadiazoyl, quinolinyl, quinazolinyl, naphthyridinyl, and carbazoyl; wherein the heteroaryl may be substituted with alkyl, aryl, a heteroatom-containing group with zero to about 36 carbon atoms, or halogen.

(13) A semiconducting polymer selected from the group consisting of Formulas (I) and (II):

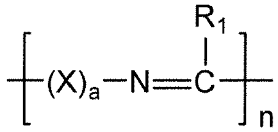

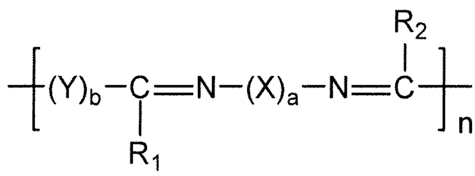

**Formula (I)** **Formula (II)**

wherein

$R_1$ and $R_2$ are independently selected from hydrogen, alkyl, substituted alkyl, aryl, substituted aryl, and heteroaryl;

each X and Y moiety is independently selected from

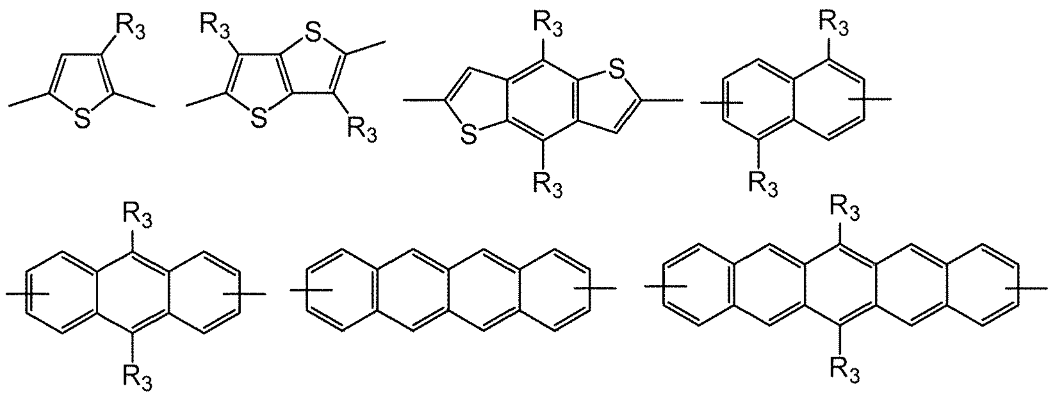

wherein $R_3$ is independently selected from hydrogen, alkyl, substituted alkyl, aryl, substituted aryl, and heteroaryl; a and b are independently integers from 0 to about 10; and n is an integer from 2 to about 5,000.

(14) The semiconducting polymer of (13), wherein a is from 1 to 6.
(15) The semiconducting polymer of (13), being of Formula (II), wherein a is zero or 1; and b is from 1 to 6.
(16) The semiconducting polymer of (13), wherein $R_1$ and $R_2$ are hydrogen.
(17) The semiconducting polymer of (13), wherein $R_1$ and $R_2$ are independently $C_1$-$C_{20}$ alkyl.
(18) The semiconducting polymer of (13), wherein $R_3$ is $C_1$-$C_{20}$ alkyl.
(19) A process for preparing a semiconducting polymer of the formula:

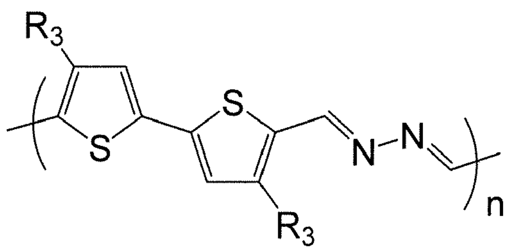

**Formula (II-j)**

wherein $R_3$ is independently selected from alkyl, substituted alkyl, aryl, substituted aryl, and heteroaryl; the process comprising:

synthesizing 5,5'-diformyl-4,4'-di($R_3$)thio-2,2'-bithiophene; and
polymerizing the 5,5'-diformyl-4,4'-di($R_3$)thio-2,2'-bithiophene with hydrazine to form polymer **II-j**.

The present disclosure is directed, in various embodiments, to semiconducting polymers suitable for use in the semiconducting layer of a thin film transistor.

The semiconducting polymer is selected from the group consisting of Formulas (I) and (II):

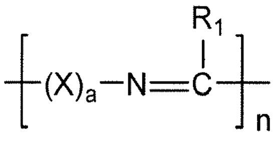

**Formula (I)**

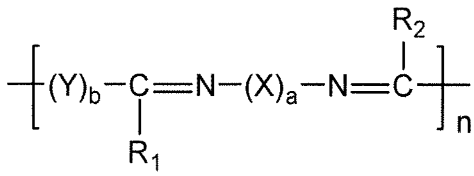

**Formula (II)**

wherein

$R_1$ and $R_2$ are independently selected from hydrogen, alkyl, substituted alkyl, aryl, substituted aryl, and heteroaryl;
X and Y are independently a conjugated divalent moiety;
a and b are independently integers from 0 to about 10; and
n is an integer from 2 to about 5,000.
X and Y may independently comprise a moiety selected from

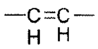 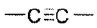 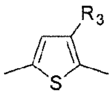 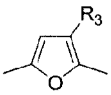 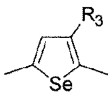 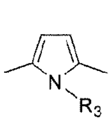 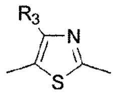 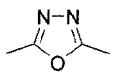

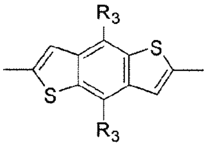 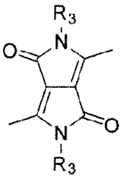 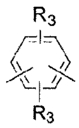 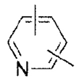 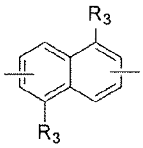 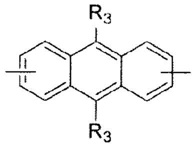

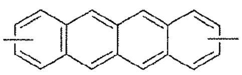 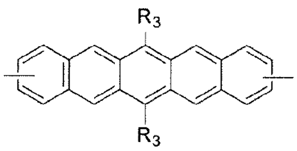 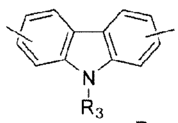 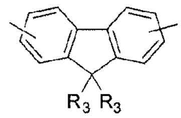

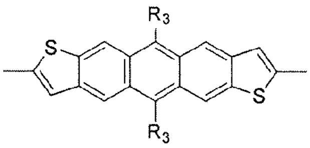 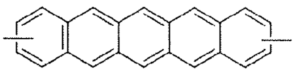 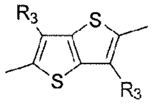

and combinations thereof, wherein $R_3$ is independently selected from hydrogen, alkyl, substituted alkyl, aryl, substituted aryl, and heteroaryl.

The semiconducting polymer may be selected from Formula (I-a) through (I-h):

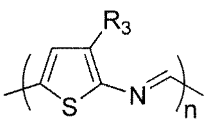

**Formula (I-a)**

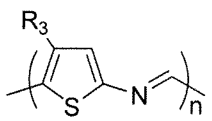

**Formula (I-b)**

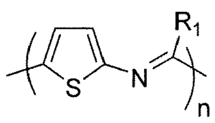

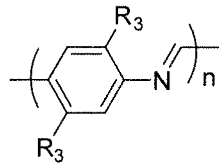

**Formula (I-c)** **Formula (I-d)**

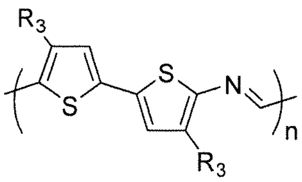

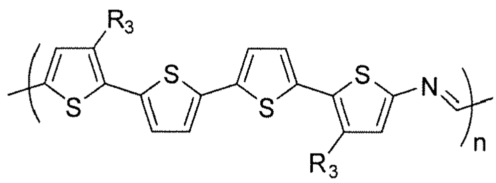

**Formula (I-e)** **Formula (I-f)**

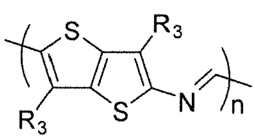

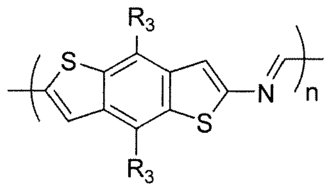

**Formula (I-g)** **Formula (I-h)**

wherein $R_1$ and $R_3$ are independently selected from alkyl, substituted alkyl, aryl, substituted aryl, and heteroaryl.

The semiconducting polymer may be selected from one of Formulas (II-a) through (II-v):

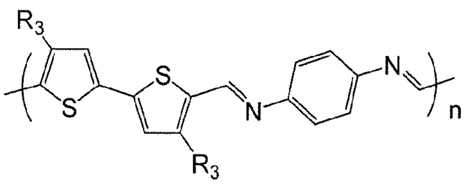

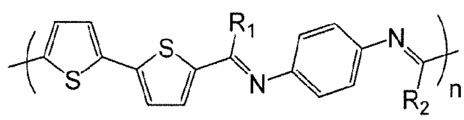

**Formula (II-a)** **Formula (II-b)**

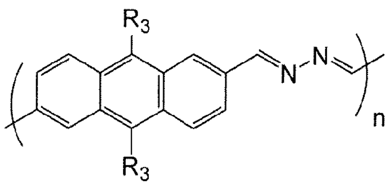

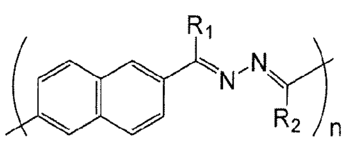

**Formula (II-c)** **Formula (II-d)**

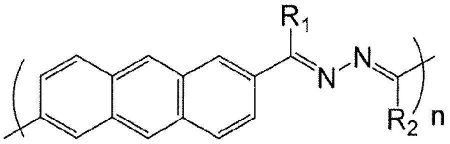

**Formula (II-e)**

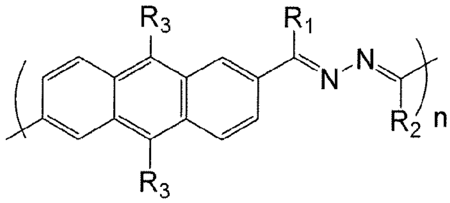

**Formula (II-f)**

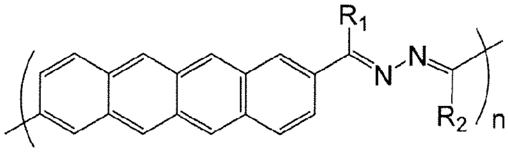

**Formula (II-g)**

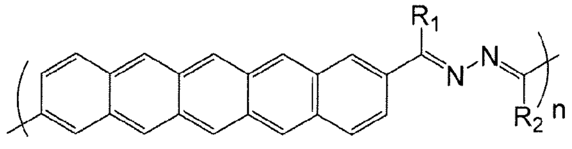

**Formula (II-h)**

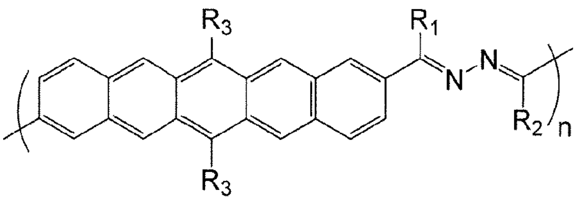

**Formula (II-i)**

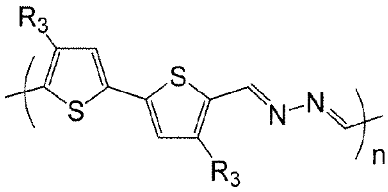

**Formula (II-j)**

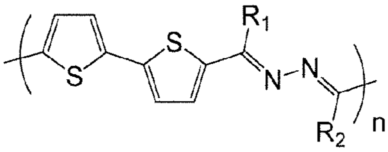

**Formula (II-k)**

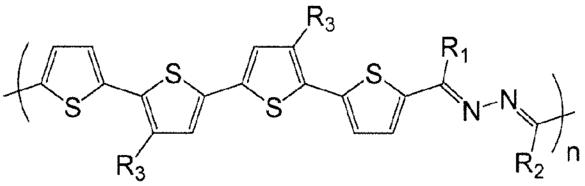

**Formula (II-l)**

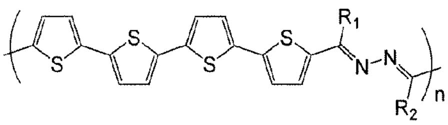

**Formula (II-m)**

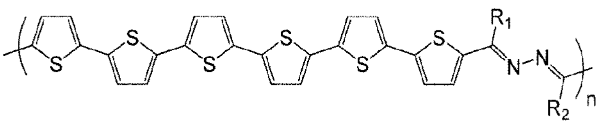

**Formula (II-n)**

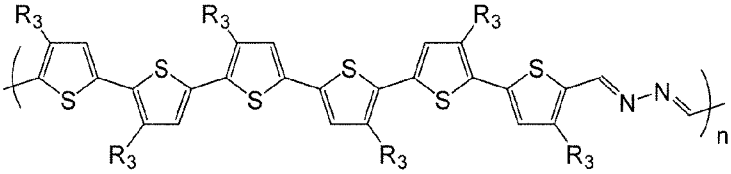

**Formula (II-o)**

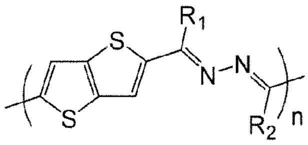

**Formula (II-p)**

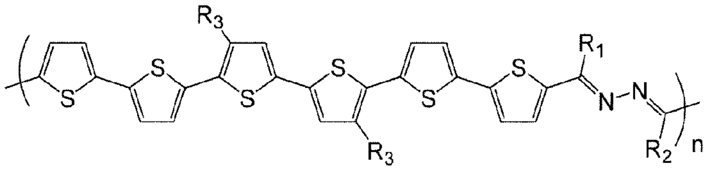

**Formula (II-q)**

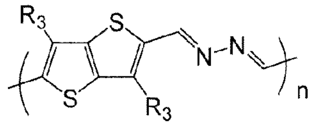

**Formula (II-r)**

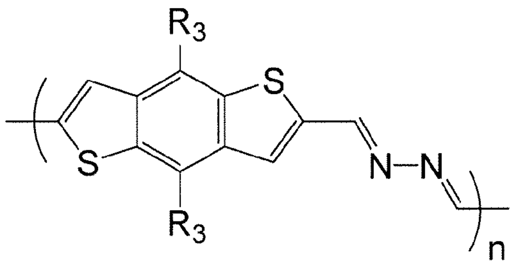

**Formula (II-s)**

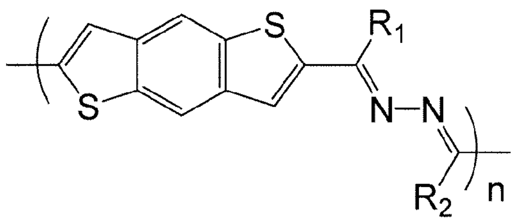

**Formula (II-t)**

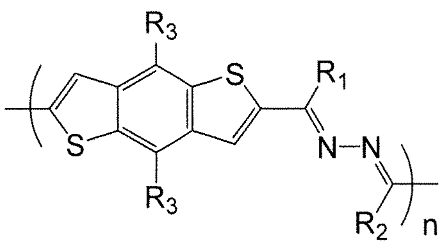

**Formula (II-u)**

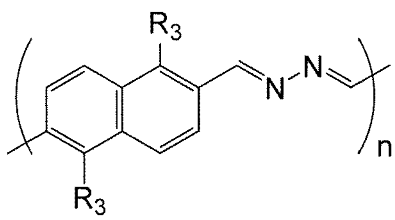

**Formula (II-v)**

wherein $R_1$, $R_2$, and $R_3$ are independently selected from alkyl, substituted alkyl, aryl, substituted aryl, and heteroaryl. In specific embodiments, $R_1$, $R_2$, and $R_3$ are independently $C_1$-$C_{20}$ alkyl.

The heteroaryl group may be selected from thienyl, furanyl, pyridinyl, oxazoyl, pyrroyl, triazinyl, imidazoyl, pyrimidinyl, pyrazinyl, oxadiazoyl, pyrazoyl, triazoyl, thiazoyl, thiadiazoyl, quinolinyl, quinazolinyl, naphthyridinyl, and carbazoyl, and the heteroaryl may be substituted with alkyl, aryl, a heteroatom-containing group with zero to about 36 carbon atoms, or halogen.

In other embodiments, the semiconducting polymer is of Formula (I) or (II):

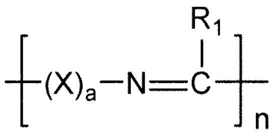

**Formula (I)**

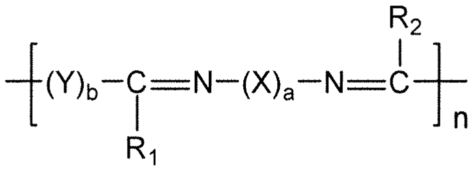

**Formula (II)**

wherein

$R_1$ and $R_2$ are independently selected from hydrogen, alkyl, substituted alkyl, aryl, substituted aryl, and heteroaryl; each X and Y moiety is independently selected from

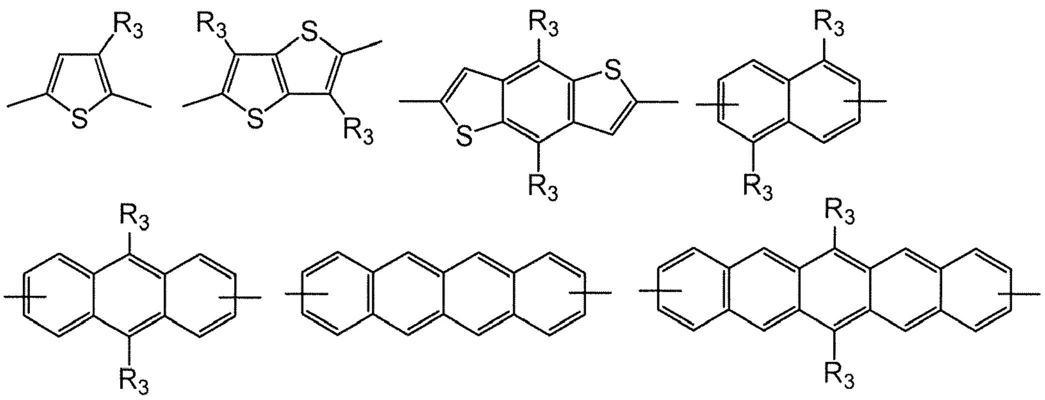

wherein $R_3$ is independently selected from hydrogen, alkyl, substituted alkyl, aryl, substituted aryl, and heteroaryl;
a and b are independently integers from 0 to about 10; and
n is an integer from 2 to about 5,000.

Also disclosed in embodiments is a process for preparing a semiconducting polymer of the formula:

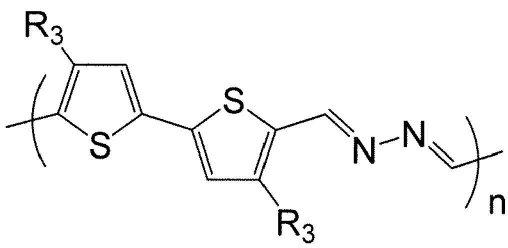

**Formula (II-j)**

wherein $R_3$ is independently selected from alkyl, substituted alkyl, aryl, substituted aryl, and heteroaryl; the process comprising:

synthesizing 5,5'-diformyl-4,4'-di($R_3$)thio-2,2'-bithiophene; and
polymerizing the 5,5'-diformyl-4,4'-di($R_3$)thio-2,2'-bithiophene with hydrazine to form polymer **II-j**.

Also included in further embodiments are the semiconducting layers and/or thin film transistors produced by this process. The transistor may have a mobility of 0.01 $cm^2/V{\bullet}sec$ or greater and/or a current on/off ratio of $10^4$ or greater.

These and other non-limiting characteristics of the exemplary embodiments of the present disclosure are more particularly described below.

## BRIEF DESCRIPTION OF THE DRAWINGS

The following is a brief description of the drawings, which are presented for the purpose of illustrating the exemplary embodiments disclosed herein and not for the purpose of limiting the same.

**FIG. 1** is a first exemplary embodiment of a TFT of the present disclosure.
**FIG. 2** is a second exemplary embodiment of a TFT of the present disclosure.
**FIG. 3** is a third exemplary embodiment of a TFT of the present disclosure.
**FIG. 4** is a fourth exemplary embodiment of a TFT of the present disclosure.

## DETAILED DESCRIPTION

A more complete understanding of the components, processes, and apparatuses disclosed herein can be obtained by reference to the accompanying figures. These figures are merely schematic representations based on convenience and the ease of demonstrating the present development and are, therefore, not intended to indicate relative size and dimensions of the devices or components thereof and/or to define or limit the scope of the exemplary embodiments.

Although specific terms are used in the following description for the sake of clarity, these terms are intended to refer only to the particular structure of the embodiments selected for illustration in the drawings and are not intended to define or limit the scope of the disclosure. In the drawings and the following description below, it is to be understood that like numeric designations refer to components of like function.

The present disclosure relates to semiconducting polymers of Formulas (I) or (II), as further described below. Those semiconducting polymers are particularly suitable for use in the semiconducting layer of a thin-film transistor or organic thin-film transistor (OTFT). Such transistors may have many different configurations.

**FIG. 1** illustrates a first OTFT embodiment or configuration. The OTFT **10** comprises a substrate **20** in contact with the gate electrode **30** and a dielectric layer **40**. Although here the gate electrode **30** is depicted within the substrate **20**, this is not required. However, of some importance is that the dielectric layer **40** separates the gate electrode **30** from the source electrode **50**, drain electrode **60**, and the semiconducting layer **70**. The source electrode **50** contacts the semiconducting layer **70**. The drain electrode **60** also contacts the semiconducting layer **70**. The semiconducting layer **70** runs over and between the source and drain electrodes **50** and **60**. Optional interfacial layer **80** is located between dielectric layer **40** and semiconducting layer **70**.

**FIG. 2** illustrates a second OTFT embodiment or configuration. The OTFT **10** comprises a substrate **20** in contact with the gate electrode **30** and a dielectric layer **40**. The semiconducting layer **70** is placed over or on top of the dielectric layer 40 and separates it from the source and drain electrodes **50** and **60**. Optional interfacial layer **80** is located between dielectric layer **40** and semiconducting layer **70**.

**FIG. 3** illustrates a third OTFT embodiment or configuration. The OTFT **10** comprises a substrate **20** which also acts as the gate electrode and is in contact with a dielectric layer **40**. The semiconducting layer **70** is placed over or on top of the dielectric layer **40** and separates it from the source and drain electrodes **50** and **60**. Optional interfacial layer **80** is located between dielectric layer **40** and semiconducting layer **70**.

**FIG. 4** illustrates a fourth OTFT embodiment or configuration. The OTFT **10** comprises a substrate **20** in contact with the source electrode **50**, drain electrode **60**, and the semiconducting layer **70**. The semiconducting layer **70** runs over and between the source and drain electrodes **50** and **60**. The dielectric layer **40** is on top of the semiconducting layer **70**. The gate electrode **30** is on top of the dielectric layer **40** and does not contact the semiconducting layer **70**. Optional interfacial layer **80** is located between dielectric layer **40** and semiconducting layer **70**.

The semiconducting polymer is selected from the group consisting of Formulas (I) and (II):

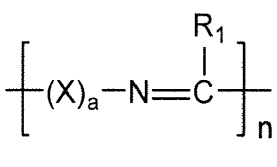

**Formula (I)**

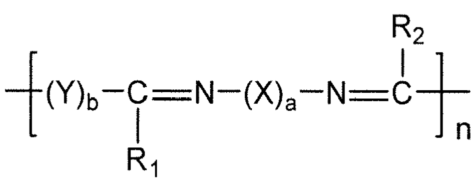

**Formula (II)**

wherein

$R_1$ and $R_2$ are independently selected from hydrogen, alkyl, substituted alkyl, aryl, substituted aryl, and heteroaryl;
X and Y are independently a conjugated divalent moiety;
a and b are independently integers from 0 to about 10; and
n is an integer from 2 to about 5,000.

Generally, the alkyl group contains 1 to about 20 carbon atoms and the aryl group contains from about 2 to about 20 carbon atoms. In some embodiments, a>0 for Formula (I) or (a+b)>0 for Formula (II). In other embodiments, a is from 1 to 6. In particular embodiments of Formula (II), a is zero. In other embodiments of Formula (II), a is zero or 1; and b is from 1 to 6. In some embodiments, $R_1$ and $R_2$ are both hydrogen, while in others $R_1$ and $R_2$ are independently $C_1$-$C_{20}$ alkyl.

Each X and Y moiety may be selected from:

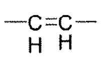 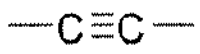 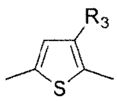 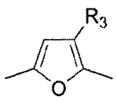 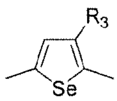 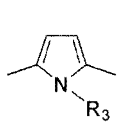 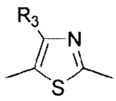 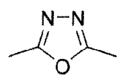

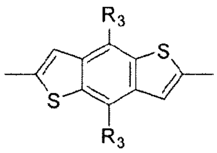 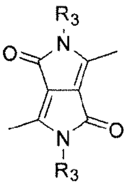 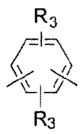 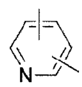 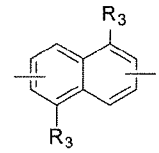 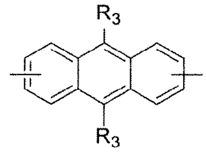

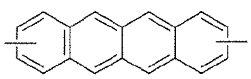 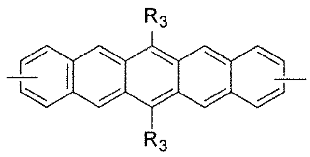 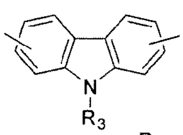 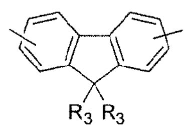

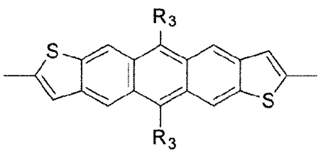 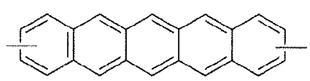 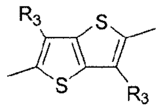

and combinations thereof, wherein $R_3$ is independently selected from hydrogen, alkyl, substituted alkyl, aryl, substituted aryl, and heteroaryl. In particular embodiments, $R_3$ is alkyl, such as $C_1$-$C_{20}$ alkyl. It should be noted that X and Y denote simply the presence of a moiety, while a and b denote the number of moieties. In other words, the X and Y moieties may be different from each other, as will be seen further herein. In addition, when a is greater than 1, for example, then the X moieties themselves may differ.

In other embodiments, X and Y are either:

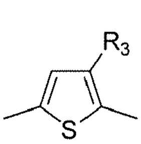 , 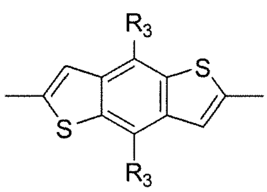 , or 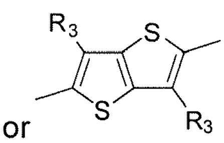 .

In embodiments, the semiconducting polymer may be selected from Formula (I-a) through (I-h):

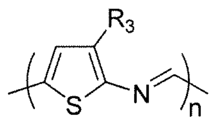

**Formula (I-a)**

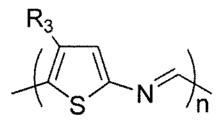

**Formula (I-b)**

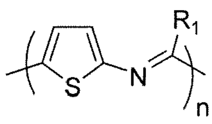

**Formula (I-c)**

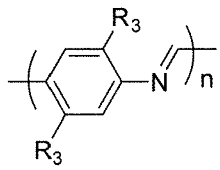

**Formula (I-d)**

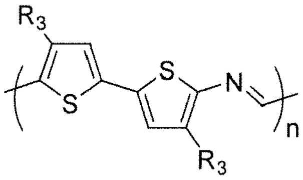

**Formula (I-e)**

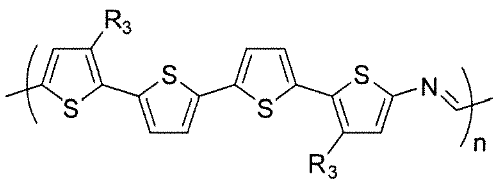

**Formula (I-f)**

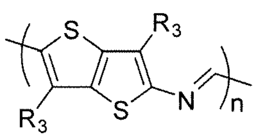

**Formula (I-g)**

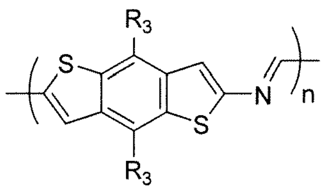

**Formula (I-h)**

wherein $R_1$ and $R_3$ are independently selected from alkyl, substituted alkyl, aryl, substituted aryl, and heteroaryl. $R_1$ and $R_3$ may be independently selected from $C_1$-$C_{20}$ alkyl.

With reference to the meaning of X and Y, in Formula (I-e), a=2. Both X moieties are the same (a thiophene with one sidechain), but the $R_3$ sidechain is on the 3-carbon on one thiophene and on the 4-carbon on the other thiophene. In Formula (I-f), a=4. Two X moieties are unsubstituted thiophene and the other two X moieties are a thiophene with one sidechain. Again, the $R_3$ sidechain is on the 3-carbon on one thiophene and on the 4-carbon on the other thiophene.

In other embodiments, the semiconducting material is selected from one of Formulas (II-a) through (II-v):

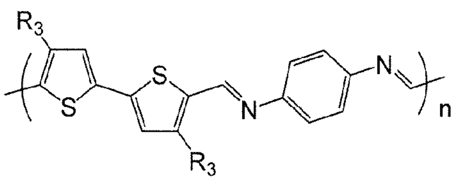

**Formula (II-a)**

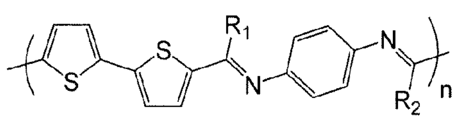

**Formula (II-b)**

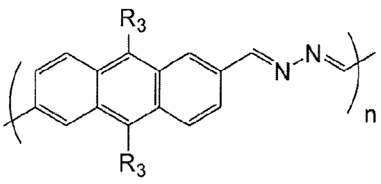

**Formula (II-c)**

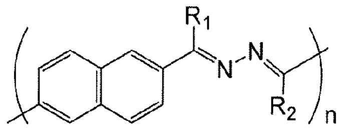

**Formula (II-d)**

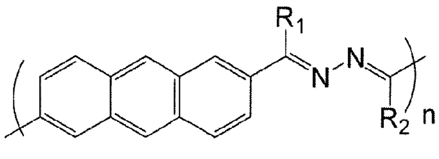

**Formula (II-e)**

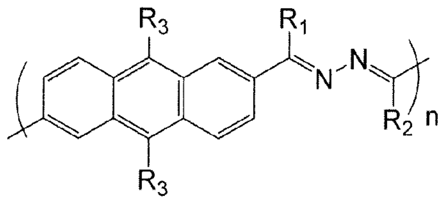

**Formula (II-f)**

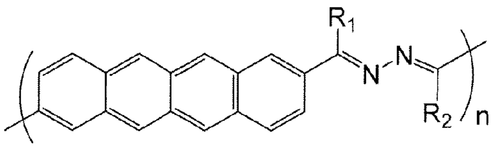

**Formula (II-g)**

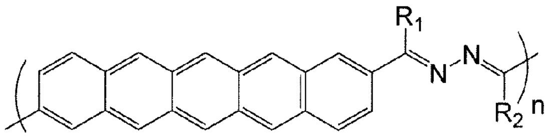

**Formula (II-h)**

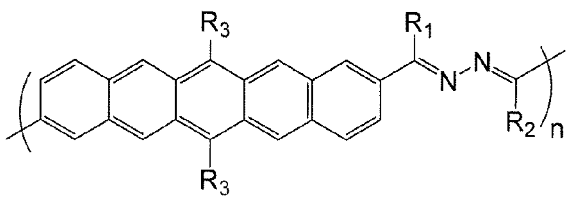

**Formula (II-i)**

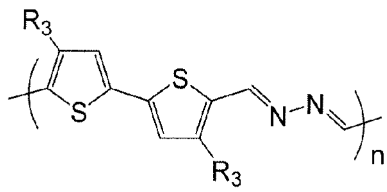

**Formula (II-j)**

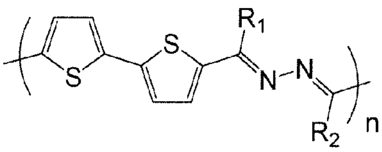

**Formula (II-k)**

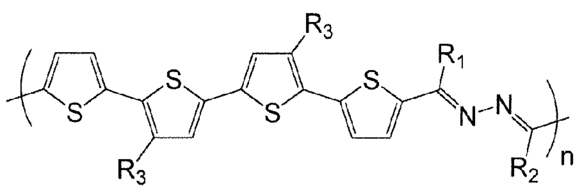

**Formula (II-l)**

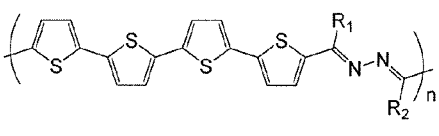

**Formula (II-m)**

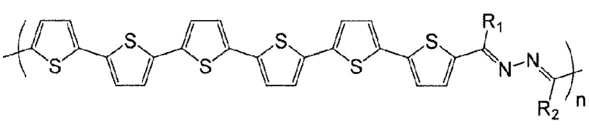

**Formula (II-n)**

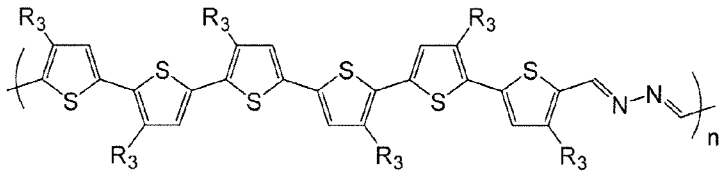

**Formula (II-o)**

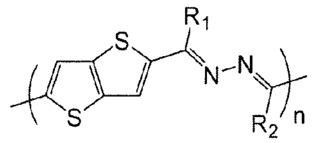

**Formula (II-p)**

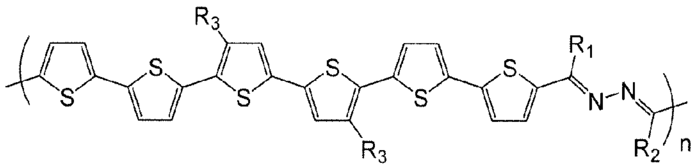

**Formula (II-q)**

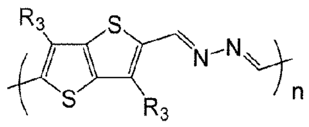

**Formula (II-r)**

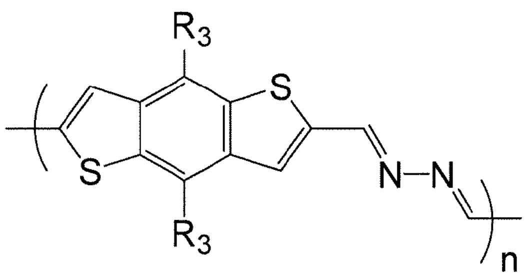

**Formula (II-s)**

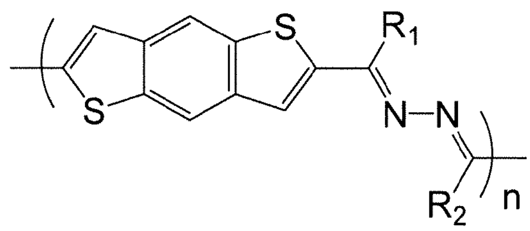

**Formula (II-t)**

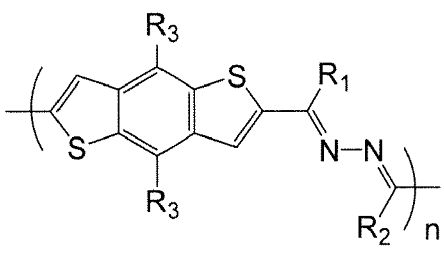

**Formula (II-u)**

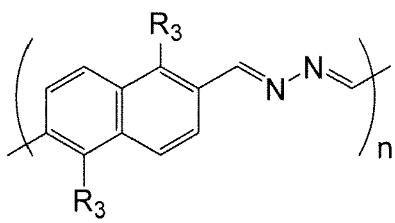

**Formula (II-v)**

wherein $R_1$, $R_2$, and $R_3$ are independently selected from alkyl, substituted alkyl, aryl, substituted aryl, and heteroaryl. In particular embodiments, $R_1$, $R_2$, and $R_3$ may be independently selected from $C_1$-$C_{20}$ alkyl. Desirably, the semiconducting polymer is of Formula (II-j).

When $R_1$, $R_2$, or $R_3$ of Formulas (I) and (II) are heteroaryl, the heteroaryl may be selected from thienyl, furanyl, pyridinyl, oxazoyl, pyrroyl, triazinyl, imidazoyl, pyrimidinyl, pyrazinyl, oxadiazoyl, pyrazoyl, triazoyl, thiazoyl, thiadiazoyl,

quinolinyl, quinazolinyl, naphthyridinyl, and carbazoyl. The heteroaryl group may be substituted with alkyl, aryl, a heteroatom-containing group having zero to about 36 carbon atoms, or halogen.

In some embodiments of Formula (I) or (II), each X and Y moiety is independently selected from

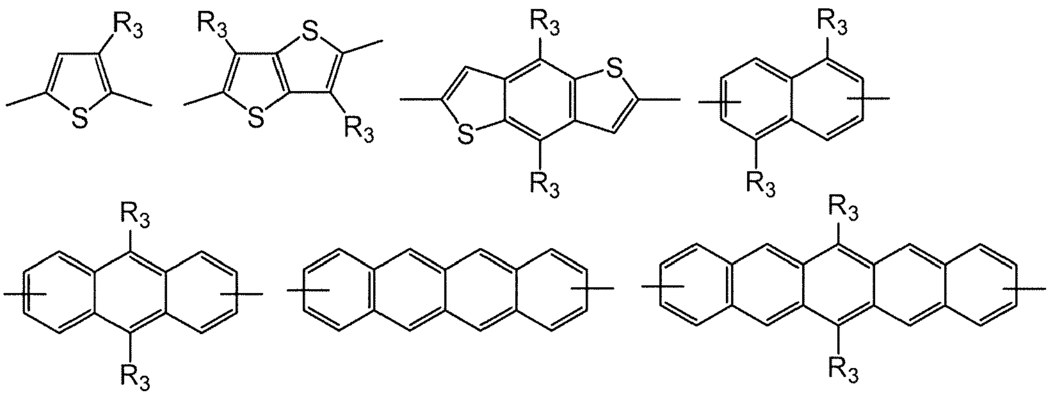

wherein $R_3$ is independently selected from hydrogen, alkyl, substituted alkyl, aryl, substituted aryl, and heteroaryl. These embodiments also cover Formulas (I-a) through (I-h) and Formulas (II-a) through (II-v).

The semiconducting polymers of Formula (I) or (II) can be formed by any suitable synthetic approach. For example, formyl or carbonyl groups can be reacted with amino groups to form the polymers (**I**) and (**II**) as illustrated in Scheme 1.

*Scheme 1. Exemplary synthesis of polymers (**I**) and (**II**).*

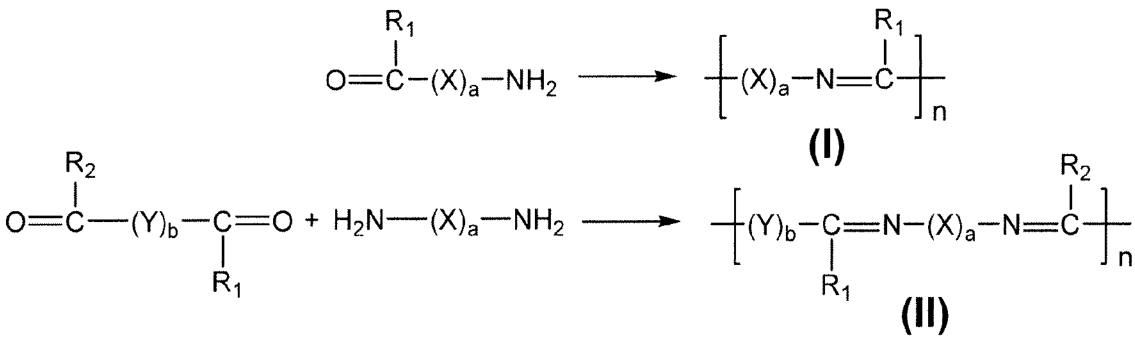

wherein

$R_1$ and $R_2$ are independently selected from hydrogen, alkyl, substituted alkyl, aryl, substituted aryl, and heteroaryl;
X and Y are independently a conjugated divalent moiety;
a and b are independently integers from 0 to about 10; and
n is an integer from 2 to about 5,000.

If desired, the semiconducting layer may further comprise another organic semiconductor material. Examples of other organic semiconductor materials include but are not limited to acenes, such as anthracene, tetracene, pentacene, and their substituted derivatives, perylenes, fullerenes, oligothiophenes, other semiconducting polymers such as triarylamine polymers, polyindolocarbazole, polycarbazole, polyacenes, polyfluorene, polythiophenes and their substituted derivatives, phthalocyanines such as copper phthalocyanines or zinc phthalocyanines and their substituted derivatives.

The semiconducting layer is from about 5 nm to about 1000 nm thick, especially from about 10 nm to about 100 nm thick. The semiconducting layer can be formed by any suitable method. However, the semiconducting layer is generally formed from a liquid composition, such as a dispersion or solution, and then deposited onto the substrate of the transistor. Exemplary deposition methods include liquid deposition such as spin coating, dip coating, blade coating, rod coating, screen printing, stamping, ink jet printing, and the like, and other conventional processes known in the art.

The substrate may be composed of materials including but not limited to silicon, glass plate, plastic film or sheet. For structurally flexible devices, plastic substrate, such as for example polyester, polycarbonate, polyimide sheets and the like may be used. The thickness of the substrate may be from about 10 micrometers to over 10 millimeters with an exemplary thickness being from about 50 micrometers to about 5 millimeters, especially for a flexible plastic substrate and from about 0.5 to about 10 millimeters for a rigid substrate such as glass or silicon.

The gate electrode is composed of an electrically conductive material. It can be a thin metal film, a conducting polymer film, a conducting film made from conducting ink or paste or the substrate itself, for example heavily doped silicon. Examples of gate electrode materials include but are not restricted to aluminum, gold, silver, chromium, indium tin oxide, conductive polymers such as polystyrene sulfonate-doped poly(3,4-ethylenedioxythiophene) (PSS-PEDOT), and conducting ink/paste comprised of carbon black/graphite or silver colloids. The gate electrode can be prepared by vacuum evaporation, sputtering of metals or conductive metal oxides, conventional lithography and etching, chemical vapor deposition, spin coating, casting or printing, or other deposition processes. The thickness of the gate electrode ranges from about 10 to about 500 nanometers for metal films and from about 0.5 to about 10 micrometers for conductive polymers.

The dielectric layer generally can be an inorganic material film, an organic polymer film, or an organic-inorganic composite film. Examples of inorganic materials suitable as the dielectric layer include silicon oxide, silicon nitride, aluminum oxide, barium titanate, barium zirconium titanate and the like. Examples of suitable organic polymers include polyesters, polycarbonates, poly(vinyl phenol), polyimides, polystyrene, polymethacrylates, polyacrylates, epoxy resin and the like. The thickness of the dielectric layer depends on the dielectric constant of the material used and can be, for example, from about 10 nanometers to about 500 nanometers. The dielectric layer may have a conductivity that is, for example, less than about $10^{-12}$ Siemens per centimeter (S/cm). The dielectric layer is formed using conventional processes known in the art, including those processes described in forming the gate electrode.

If desired, an interfacial layer may be placed between the dielectric layer and the semiconducting layer. As charge transport in an organic thin film transistor occurs at the interface of these two layers, the interfacial layer may influence the TFT's properties. Exemplary interfacial layers may be formed from silanes, such as those described in U.S. Patent Application Serial No. 12/101,942, filed April 11, 2008.

Typical materials suitable for use as source and drain electrodes include those of the gate electrode materials such as gold, silver, nickel, aluminum, platinum, conducting polymers, and conducting inks. In specific embodiments, the electrode materials provide low contact resistance to the semiconductor. Typical thicknesses are about, for example, from about 40 nanometers to about 1 micrometer with a more specific thickness being about 100 to about 400 nanometers. The OTFT devices of the present disclosure contain a semiconductor channel. The semiconductor channel width may be, for example, from about 5 micrometers to about 5 millimeters with a specific channel width being about 100 micrometers to about 1 millimeter. The semiconductor channel length may be, for example, from about 1 micrometer to about 1 millimeter with a more specific channel length being from about 5 micrometers to about 100 micrometers.

The source electrode is grounded and a bias voltage of, for example, about 0 volt to about 80 volts is applied to the drain electrode to collect the charge carriers transported across the semiconductor channel when a voltage of, for example, about +10 volts to about -80 volts is applied to the gate electrode. The electrodes may be formed or deposited using conventional processes known in the art.

If desired, a barrier layer may also be deposited on top of the TFT to protect it from environmental conditions, such as light, oxygen and moisture, etc. which can degrade its electrical properties. Such barrier layers are known in the art and may simply consist of polymers.

The various components of the OTFT may be deposited upon the substrate in any order, as is seen in the Figures. The term "upon the substrate" should not be construed as requiring that each component directly contact the substrate. The term should be construed as describing the location of a component relative to the substrate. Generally, however, the gate electrode and the semiconducting layer should both be in contact with the dielectric layer. In addition, the source and drain electrodes should both be in contact with the semiconducting layer. The semiconducting polymer formed by the methods of the present disclosure may be deposited onto any appropriate component of an organic thin-film transistor to form a semiconducting layer of that transistor.

The resulting transistor may have, in embodiments, a mobility of 0.001 $cm^2/V \cdot sec$ or greater. In some embodiments, the mobility is 0.01 $cm^2/V \cdot sec$ or greater.

The following examples illustrate an OTFT made according to the methods of the present disclosure. The examples are merely illustrative and are not intended to limit the present disclosure with regard to the materials, conditions, or process parameters set forth therein. All parts are percentages by weight unless otherwise indicated.

## EXAMPLE

### Poly(1,2-bis((3-dodecyl-5-methylthiophen-2-yl)methylene)hydrazine)

The synthesis of poly(1,2-bis((3-dodecyl-5-methylthiophen-2-yl)methylene)hydrazine), Formula (II-j), is outlined in Scheme 2.

*Scheme 2.*

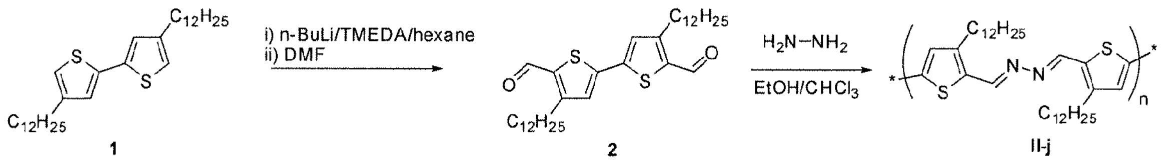


1 2 II-j

Synthesis of 5,5'-diformyl-4,4'-didodecylthio-2,2'-bithiophene **2**.

Under argon atmosphere, a hexane solution (18.65 mmol, 7.46 mL, 2.5 M) of n-butyllithium was added over 10 minutes to a mixture of N,N,N'N'-tetramethylethylenediamine (TMEDA) (18.65 mmol) and solid 3,4'-didodecylthiophene 1 (9.33 mmol) in dry hexane (100 mL). The solid was dissolved to become a yellow transparent solution and then light yellow precipitate formed. 40 mL of additional hexane was added. The mixture was stirred for 30 minutes at reflux and then cooled to -78°C. An excess of dry N,N-dimethylformamide (DMF) (32 mmol) was added dropwise under argon over 5 minutes. The mixture became yellow immediately. The reaction mixture was left to reach room temperature (overnight) and the obtained solution was poured into a 3.7% aqueous HCl solution (400 mL), under vigorous stirring and kept below 0°C. After neutralization with sodium hydrogen carbonate, the organic layer was extracted several times with ether and dried with sodium sulfate. The solid was crystallized using first isopropanol and then heptane.
Yield: 4.35 g (83.5%).

Synthesis of **II-j**.

Hydrazine (52.67 mg, 1.052 mmol) and 5,5'-diformyl-4,4'-didodecylthio-2,2'-bithiophene **2** (0.5881 g, 1.052 mmol) was mixed in ethanol (20 mL) and chloroform (10 mL). The mixture was heated 24 hours at reflux, then was cooled down to room temperature and poured into methanol (200 mL). After filtration the solid was stirred in an aqueous sodium hydrogen carbonate solution and then filtered. The solid was purified by Sohxlet extraction using hexane for 24 hours and then dissolved with toluene. Removal of solvent gave **II-j** as dark purple metallic flakes.
Yield: 0.21 g (36%).
DSC: melting points: 170°C; 211°C.
GPC: $M_w/M_n$ = 45066/21349 = 2.11

### OTFT fabrication and characterization

A top-contact thin film transistor configuration as schematically illustrated in FIG. 3 was used for the test device structure. The test device was built on an n-doped silicon wafer with a thermally grown silicon oxide layer with a thickness of about 200 nanometers thereon, and had a capacitance of about 15 nF/cm$^2$ (nanofarads/square centimeter), as measured with a capacitor meter. The wafer functioned as the gate electrode while the silicon oxide layer acted as the gate dielectric. The silicon wafer was first cleaned with isopropanol, argon plasma, isopropanol and air dried, and then immersed in a 0.1 M solution of octyltrichlorosilane (OTS-8) in toluene at 60°C for 20 min. Subsequently, the wafer was washed with toluene, isopropanol and air-dried. A solution of polymer (**II-j**) dissolved in dichlorobenzene (0.5 percent by weight) was first filtered through a 1.0 micrometer syringe filter, and then spin-coated on the OTS-8-treated silicon wafer at 1000 rpm for 120 seconds at room temperature. This resulted in the formation of a semiconductor layer with a thickness of 20-50 nanometers on the silicon wafer, which was then dried in a vacuum oven at 80°C for 5-10 hours. Subsequently, gold source and drain electrodes of about 50 nanometers in thickness were deposited on top of the semiconductor layer by vacuum deposition through a shadow mask with various channel lengths and widths, thus

creating a series of transistors of various dimensions. The devices were annealed at 140°C for 10-15 minutes before evaluation.

The evaluation of transistor performance was accomplished in a black box (that is, a closed box which excluded ambient light) at ambient conditions using a Keithley 4200 SCS semiconductor characterization system. The carrier mobility, $\mu$, was calculated from the data in the saturated regime (gate voltage, $V_G$ < source-drain voltage, $V_{SD}$) according to equation (1)

$$I_{SD} = C_i \, \mu \, (W/2L) \, (V_G - V_T)^2 \qquad (1)$$

where $I_{SD}$ is the drain current at the saturated regime, W and L are, respectively, the semiconductor channel width and length, $C_i$ is the capacitance per unit area of the gate dielectric layer, and $V_G$ and $V_T$ are, respectively, the gate voltage and threshold voltage. $V_T$ of the device was determined from the relationship between the square root of $I_{SD}$ at the saturated regime and $V_G$ of the device by extrapolating the measured data to $I_{SD}$ = 0.

The transfer and output characteristics of the devices showed that the compound was a p-type semiconductor. Using transistors with a dimension of W = 5,000 $\mu$m and L = 90 $\mu$m, the following average properties from at least five transistors were obtained:

Mobility: 0.03 $cm^2$/V·sec.
On/off ratio: $10^6$.

The OTFT devices were fabricated and measured entirely under ambient conditions, indicating the excellent air-stability of this type of polymers.

## Claims

1. A semiconducting polymer selected from the group consisting of Formulas (I) and (II):

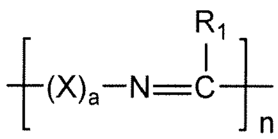

**Formula (I)**

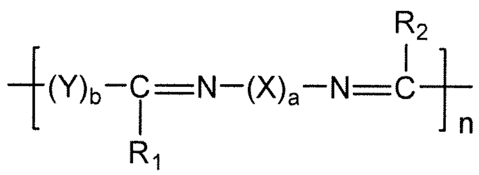

**Formula (II)**

wherein

$R_1$ and $R_2$ are independently selected from hydrogen, alkyl, substituted alkyl, aryl, substituted aryl, and heteroaryl;
X and Y are independently a conjugated divalent moiety;
a and b are independently integers from 0 to about 10; and
n is an integer from 2 to about 5,000.

2. The semiconducting polymer of claim 1, wherein each X and Y moiety is selected from

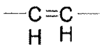 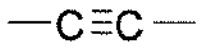 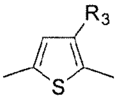 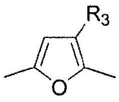 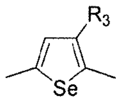 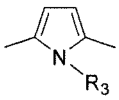 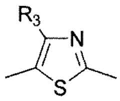 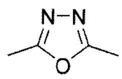

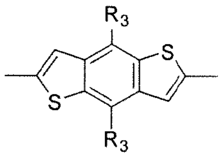 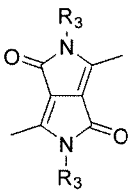 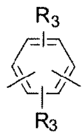 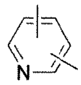 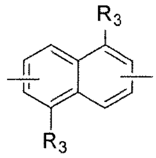 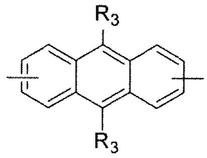

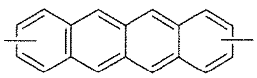 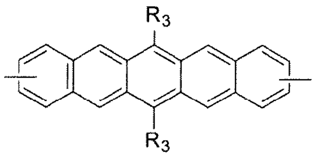 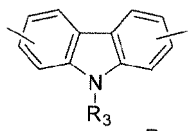 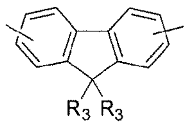

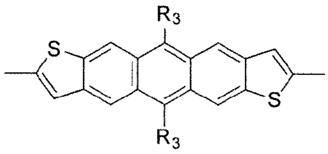 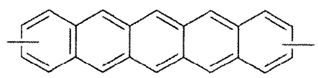 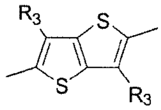

wherein $R_3$ is independently selected from hydrogen, alkyl, substituted alkyl, aryl, substituted aryl, and heteroaryl.

**3.** The semiconducting polymer of claim 1, wherein $R_1$ and $R_2$ are hydrogen.

**4.** The semiconducting polymer of claim 1, wherein $R_1$ and $R_2$ are independently $C_1$-$C_{20}$ alkyl.

**5.** The semiconducting polymer of claim 1, being of Formula (II), wherein a is zero.

**6.** The semiconducting polymer of claim 1, wherein the semiconducting polymer is selected from Formula (I-a) through (I-h):

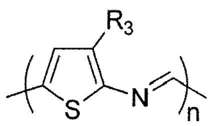

**Formula (I-a)**

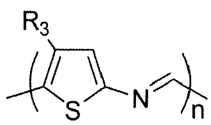

**Formula (I-b)**

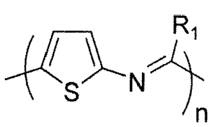

**Formula (I-c)**

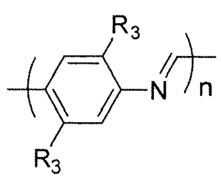

**Formula (I-d)**

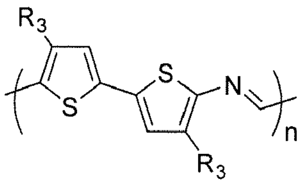

**Formula (I-e)**

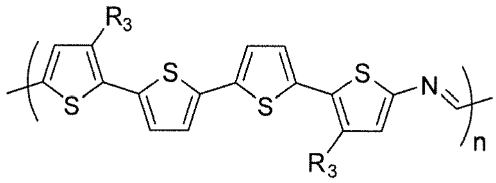

**Formula (I-f)**

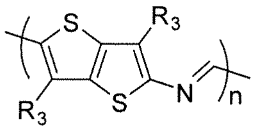

**Formula (I-g)**

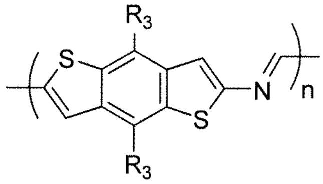

**Formula (I-h)**

wherein $R_1$ and $R_3$ are independently selected from alkyl, substituted alkyl, aryl, substituted aryl, and heteroaryl.

**7.** The semiconducting polymer of claim 6, wherein the semiconducting polymer is Formula (I-b).

**8.** The semiconducting polymer of claim 1, wherein the semiconducting material is selected from one of Formulas (II-a) through (II-v):

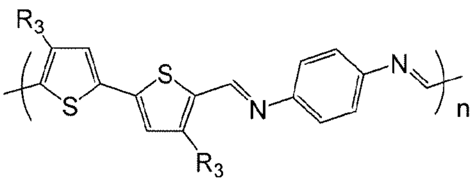

**Formula (II-a)**

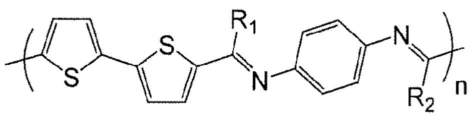

**Formula (II-b)**

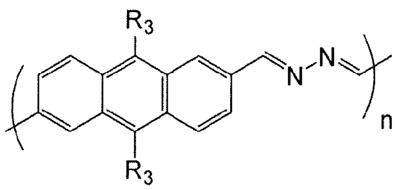

**Formula (II-c)**

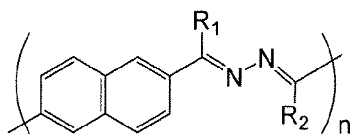

**Formula (II-d)**

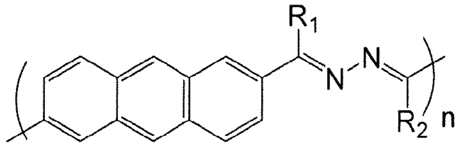

**Formula (II-e)**

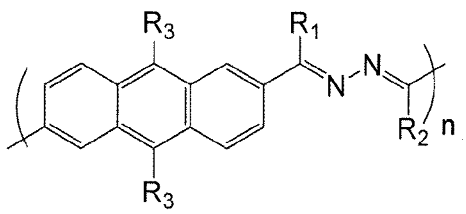

**Formula (II-f)**

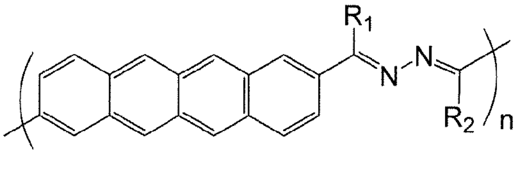

**Formula (II-g)**

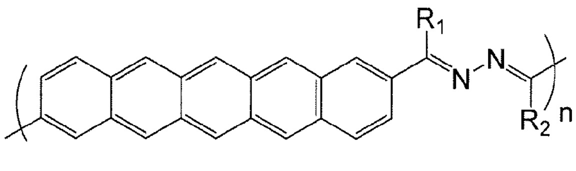

**Formula (II-h)**

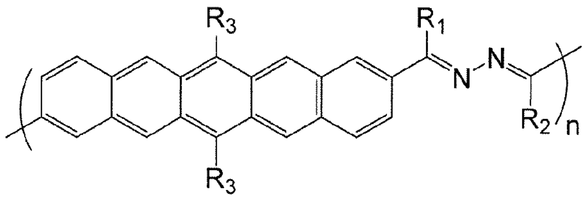

**Formula (II-i)**

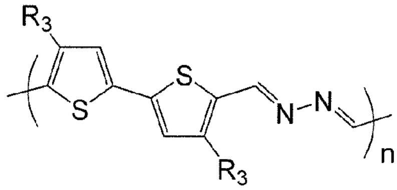

**Formula (II-j)**

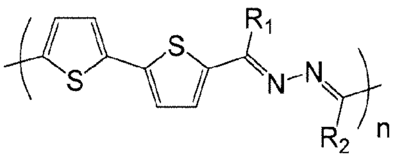

**Formula (II-k)**

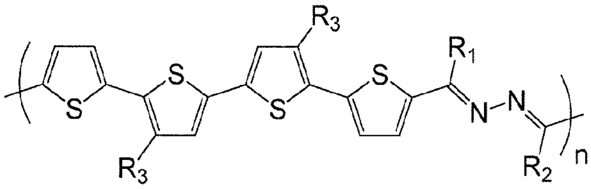

**Formula (II-l)**

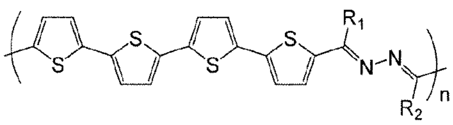

**Formula (II-m)**

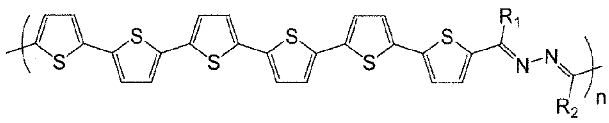

**Formula (II-n)**

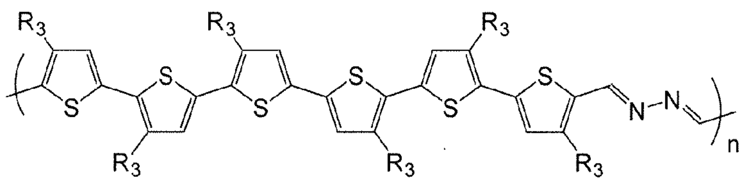

**Formula (II-o)**

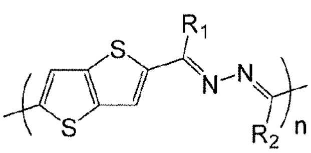

**Formula (II-p)**

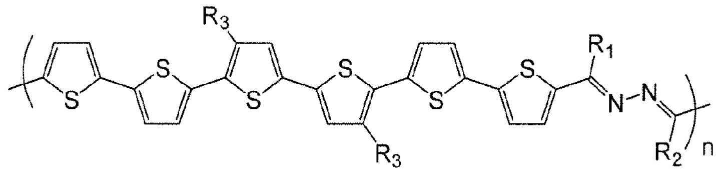

**Formula (II-q)**

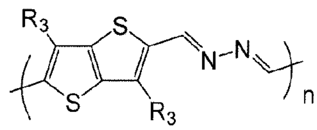

**Formula (II-r)**

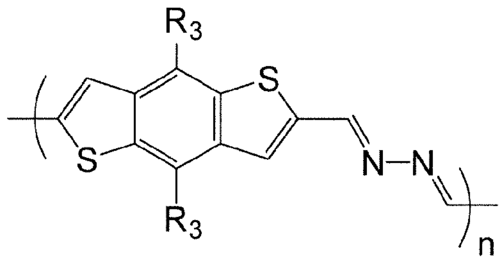

**Formula (II-s)**

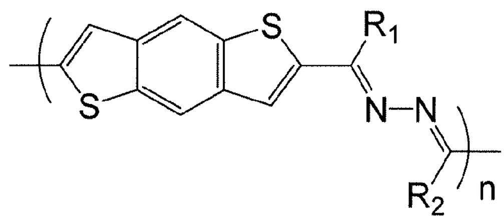

**Formula (II-t)**

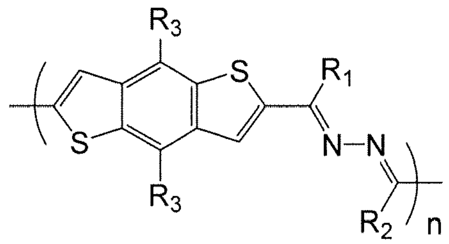

**Formula (II-u)**

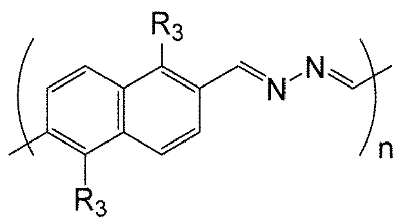

**Formula (II-v)**

wherein $R_1$, $R_2$, and $R_3$ are independently selected from alkyl, substituted alkyl, aryl, substituted aryl, and heteroaryl.

**9.** The semiconducting polymer of claim 8, wherein $R_1$, $R_2$, and $R_3$ are independently $C_1$-$C_{20}$ alkyl.

**10.** The semiconducting polymer of claim 8, wherein the semiconducting polymer is Formula (II-j.)

**11.** A semiconducting polymer selected from the group consisting of Formulas (I) and (II):

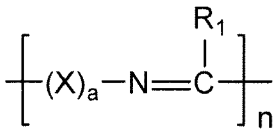

**Formula (I)**

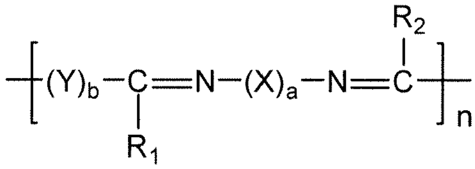

**Formula (II)**

wherein

$R_1$ and $R_2$ are independently selected from hydrogen, alkyl, substituted alkyl, aryl, substituted aryl, and heteroaryl;
each X and Y moiety is independently selected from

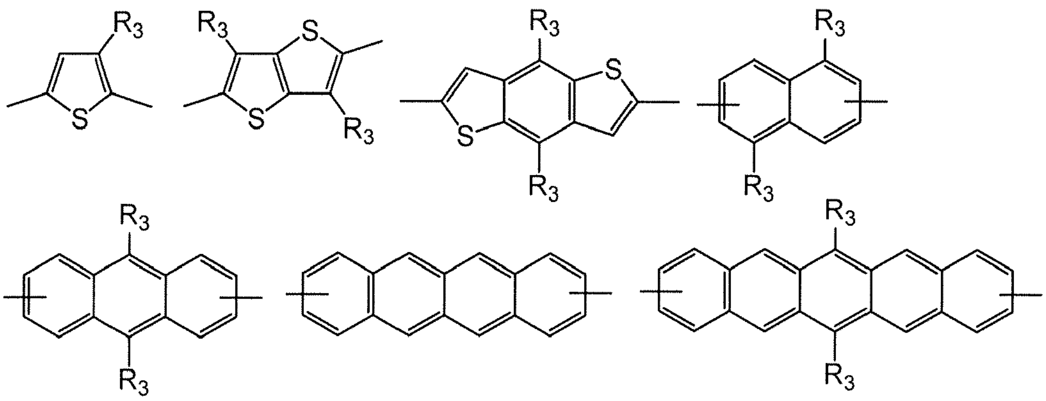

wherein $R_3$ is independently selected from hydrogen, alkyl, substituted alkyl, aryl, substituted aryl, and heteroaryl;
a and b are independently integers from 0 to about 10; and
n is an integer from 2 to about 5,000.

**12.** The semiconducting polymer of claim 11, wherein a is from 1 to 6.

**13.** The semiconducting polymer of claim 11, being of Formula (II), wherein a is zero or 1; and b is from 1 to 6.

**14.** The semiconducting polymer of claim 11, wherein $R_1$ and $R_2$ are hydrogen.

**15.** A process for preparing a semiconducting polymer of the formula:

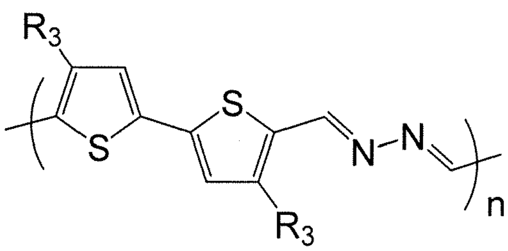

**Formula (II-j)**

wherein $R_3$ is independently selected from alkyl, substituted alkyl, aryl, substituted aryl, and heteroaryl; the process comprising:

synthesizing 5,5'-diformyl-4,4'-di($R_3$)thio-2,2'-bithiophene; and
polymerizing the 5,5'-diformyl-4,4'-di($R_3$)thio-2,2'-bithiophene with hydrazine to form polymer **II-j.**

FIG. 1

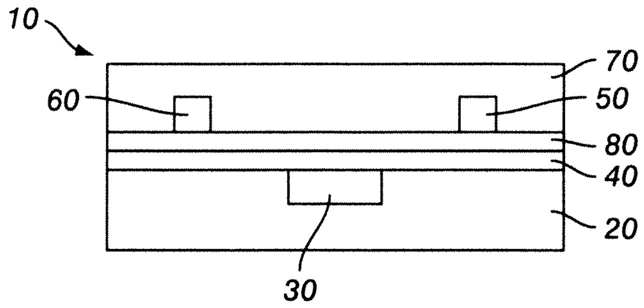


FIG. 2

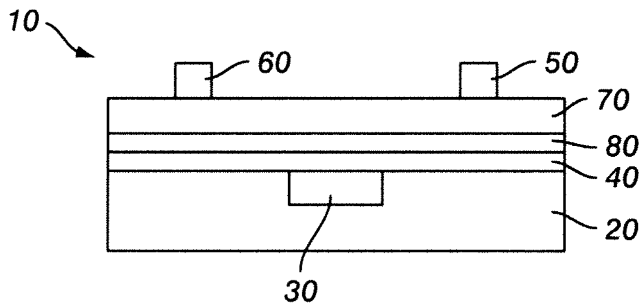


FIG. 3

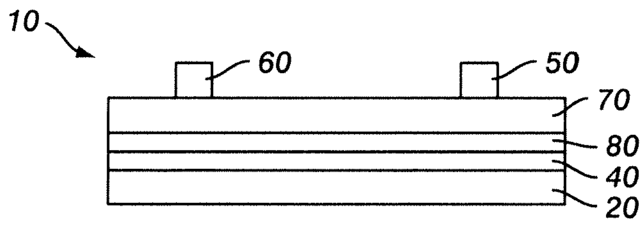


FIG. 4

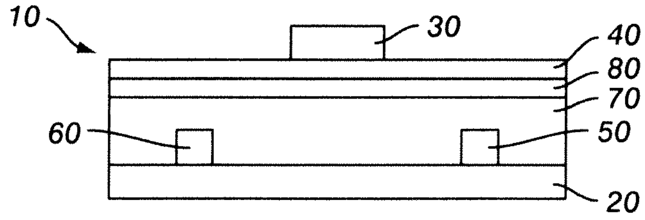

Europäisches Patentamt
European Patent Office
Office européen des brevets

# EUROPEAN SEARCH REPORT

Application Number
EP 09 16 7040

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 3 418 281 A (SMITH HARRY A ET AL) 24 December 1968 (1968-12-24) * claims 1-6; examples 1-3 * ----- | 1-3,12 | INV. C08G73/00 C08G12/06 C08G12/26 |
| X | US 2004/077819 A1 (IRIKURA HAGANE [JP] ET AL) 22 April 2004 (2004-04-22) * paragraph [0018]; claim 9 * ----- | 1-3,12, 13 | |
| X | WANG X ET AL: "Novel polyimine as electroluminescent material prepared by vapor deposition polymerization" THIN SOLID FILMS, ELSEVIER-SEQUOIA S.A. LAUSANNE, CH, vol. 438-439, 22 August 2003 (2003-08-22), pages 75-79, XP004447967 ISSN: 0040-6090 * figure 1 * ----- | 1-3,8, 11,12 | |
| X | WO 2005/073265 A (UNIV MONTREAL [CA]; SKENE WILLIAM G [CA]) 11 August 2005 (2005-08-11) * page 2 - page 55; claims 1-3 * ----- | 1-15 | TECHNICAL FIELDS SEARCHED (IPC) |
| X | WO 2004/003044 A (LEHN JEAN-MARIE [FR]; SKENE W G [FR]) 8 January 2004 (2004-01-08) * page 2 - page 33; claims 1-19 * ----- | 1-15 | C08G C08L C08F C08C H01L |
| X | US 5 814 833 A (JENEKHE SAMSON A [US]) 29 September 1998 (1998-09-29) * column 34 * ----- | 1 | |

The present search report has been drawn up for all claims

1

| Place of search | Date of completion of the search | Examiner |
|---|---|---|
| Munich | 22 October 2009 | olde Scheper, Bernd |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 09 16 7040

This annex lists the patent family members relating to the patent documents cited in the above-mentioned European search report.
The members are as contained in the European Patent Office EDP file on
The European Patent Office is in no way liable for these particulars which are merely given for the purpose of information.

22-10-2009

| Patent document cited in search report | | Publication date | Patent family member(s) | | Publication date |
|---|---|---|---|---|---|
| US 3418281 | A | 24-12-1968 | NONE | | |
| US 2004077819 | A1 | 22-04-2004 | CN 1495218 | A | 12-05-2004 |
| | | | EP 1396514 | A1 | 10-03-2004 |
| | | | JP 2004115777 | A | 15-04-2004 |
| | | | KR 20040022167 | A | 11-03-2004 |
| WO 2005073265 | A | 11-08-2005 | JP 2007520602 | T | 26-07-2007 |
| | | | US 2007287842 | A1 | 13-12-2007 |
| WO 2004003044 | A | 08-01-2004 | AU 2003240211 | A1 | 19-01-2004 |
| US 5814833 | A | 29-09-1998 | WO 9512628 | A1 | 11-05-1995 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 10194208 A